# EUROPEAN PATENT APPLICATION

(11) **EP 1 124 332 A1**
(43) Date of publication of application: **16.08.2001**
(21) Application number: 01102545.9
(22) Date of filing: 06.02.2001
(51) Int. Cl.: H03M 13/15, G06F 11/10

(54) **Error detection and correction interleave system**

(30) Priority: 08.02.2000 US 500759
(71) Applicant: THE BOEING COMPANY, Seattle, Washington 98124-2207 (US)
(72) Inventor: Chow, Harry H., Walnut, CA 91789 (US); Kohnen, Kirk, Fullerton, CA 92833 (US)
(74) Representative: Lindner, Michael, Dipl.-Ing.

(57) **Abstract**

An error detection and correction interleave system (18) has *M* memory devices (20) for storing electronic data and a controller (22) to insure data integrity. Each memory device (20) has a plurality of memory addresses (28) corresponding to a plurality of *N* bit words (26). Each *N* bit word (26) in each memory device (20) has a unique memory address (28). A controller (22) is coupled to the *M* memory devices (20) and collects one bit from each *N* bit word (26) from each memory device (20) for each memory address (28). This generates a total of *N* EDAC groupings (30), each having a length of *M* bits. The controller then generates *N* error detection and correction codes for each EDAC grouping (30) (Fig. 2).

## Description

### TECHNICAL FIELD

The present invention relates generally to electronic data storage, and more particularly, to an error detection and correction interleave system.

### BACKGROUND ART

Satellites and other spacecraft are in widespread use for various purposes including scientific research and communications. These scientific and communications missions, however, cannot be accurately fulfilled without maintaining electronic data integrity. In many applications, the satellite relies upon electronic data to perform attitude and position corrections, diagnostic status checks, communication calculations and other functions. Without accurate electronic data, proper satellite function is hindered and at times adversely affected.

In an effort to insure proper electronic data integrity, several methods have been used. Memory error detection and correcting (EDAC) codes, such as Hamming codes, have been used to insure proper electronic data integrity. Unfortunately, while it is simple to generate and implement EDAC codes capable of correcting single bit errors using Hamming codes, it is more difficult to generate double and triple bit error detection. This is especially problematic considering that memory devices are typically at least four bits wide. If a memory device fails, then the EDAC would have a four-bit error detection and correction. While it is theoretically possible to generate a Hamming EDAC code capable of correcting a four-bit memory error, it is impractical to implement. While Reed Solomon EDAC codes are capable of correcting such errors, because of their large block sizes, they are not appropriate for protecting microprocessor memory.

Other approaches have been developed for detecting all possible multiple bit errors contained within a given memory device. These approaches, however, are not appropriate for spaceborn systems. Spaceborn systems require not only the ability to detect memory device failures, but to function with failed devices in an environment in which memory devices are susceptible to random radiation induced errors.

Another method used to insure proper electronic data integrity involves using radiation hardened integrated circuits. Use of radiation hardened components reduces the possibility of radiation induced failures and errors. Unfortunately, memory devices resistant to radiation induced logical upsets are expensive. Also, while radiation hardened components reduce the possibility of radiation induced failures and errors, they do not protect against other failures.

Ultimately, the desire is to use an EDAC that is practical to implement and is capable of correcting a memory error caused by a memory device failure. The need also exists to eliminate the need for radiation hardened memory devices.

### SUMMARY OF THE INVENTION

It is, therefore, an object of the invention to provide an improved and reliable error detection and correction interleave system. Another object of the invention is to provide an EDAC that is practical to implement and is capable of correcting a memory error caused by a memory device failure. An additional object of the invention is to eliminate the need for radiation hardened memory devices.

In one embodiment of the invention, an error detection and correction interleave system has *M* memory devices for storing electronic data and a controller to insure data integrity. Each memory device has a plurality of memory addresses corresponding to a plurality of *N* bit words. Each *N* bit word in each memory device has a unique memory address. A controller is coupled to the *M* memory devices and collects one bit from each *N* bit word from each memory device for each memory address. This generates a total of *N* EDAC groupings, each having a length of *M* bits. The controller then generates *N* error detection and correction codes for each EDAC grouping.

The present invention thus achieves an improved error detection and correction interleave system. The present invention is advantageous in that it is extremely tolerant of random errors when all memory devices are functional.

Additional advantages and features of the present invention will become apparent from the description that follows, and may be realized by means of the instrumentalities and combinations particularly pointed out in the appended claims, taken in conjunction with the accompanying drawings.

### BRIEF DESCRIPTION OF THE DRAWINGS

In order that the invention may be well understood, there will now be described some embodiments thereof, given by way of example, reference being made to the accompanying drawings, in which:
FIGURE 1 depicts a satellite system in which an error detection and correction interleave system in accordance with the present invention can be utilized; and
FIGURE 2 schematically illustrates an error detection and correction interleave system in accordance with a preferred embodiment of the present invention.

### BEST MODES FOR CARRYING OUT THE INVENTION

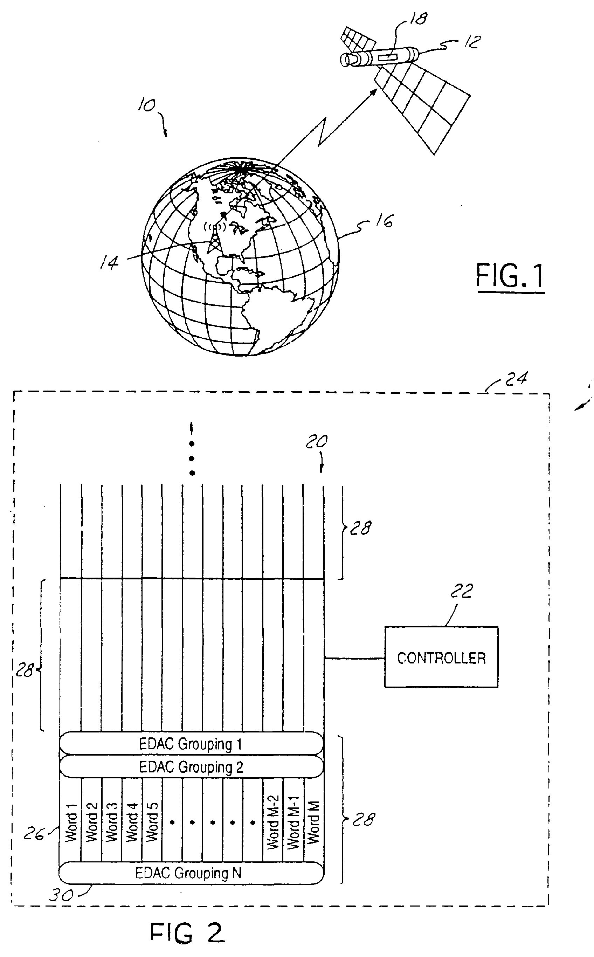

Referring to FIGURE 1, a perspective view of a satellite error detection and correction interleave system 10 in accordance with one embodiment of the present invention is illustrated. The satellite error detection and correction interleave system 10 is utilized with one or more satellites 12 which are in communication with a ground station 14 located on the Earth 16. Each satellite 12 contains one or more error detection and correction interleave systems 18.

The satellite error detection and correction interleave system 10 is responsible for insuring electronic data integrity. Satellite scientific and communications missions cannot be accurately fulfilled without maintaining electronic data integrity. In many applications, the satellite relies upon electronic data to perform attitude and position corrections, diagnostic status checks, communication calculations and other functions. Without accurate electronic data, proper satellite function is hindered and at times impossible.

Referring to FIGURE 2, a block diagram of an error detection and correction interleave system 18 in accordance with a preferred embodiment of the present invention is illustrated. The error detection and correction interleave system 18 includes *M* memory devices 20 coupled to a controller 22. In one embodiment of the invention, the memory devices 20 and controller 22 are housed in an electronic module 24.

Satellite 12 uses *M* memory devices 20 to store electronic data. Data is stored in these memory devices 20 in finite strings of data called words 26 located at unique locations in each memory device called memory addresses 28. Each memory device 20 has a plurality of memory addresses 28 for storing a plurality of *N* bit words 26. For any given memory address 28, *M* memory devices 20 will generate *M* words 26 of *N* bit length. One skilled in the art would realize that any type of electronic memory might be used in the present invention.

Satellite 12 uses controller 22 to insure the integrity of the electronic data by using error detection and correction (EDAC) codes. Controller 22 is coupled to *M* memory devices 20 and may be either hardware (discrete components) or software based. Controller 22 collects the first bit from each *N* bit word 26 located at a specific memory address 28 of each memory device 20. This results in a data string having *M* bits, also called an *M* bit word or EDAC grouping 30. The process is then repeated for all *N* bits until *N* EDAC groupings of *M* bit length are generated.

Controller 22 then applies an error detection and correction code to each EDAC grouping. If controller 22 is hardware based, then an error detection and correction code circuit generates the EDAC codes. If controller 22 is microprocessor based, then an error detection and correction code algorithm generates the EDAC codes. The EDAC code can be, but is not limited to, a Hamming code based EDAC. The EDAC code must be capable of correcting single bit errors, but preferably capable of correcting double bit errors while detecting triple bit errors.

The present invention handles low probability random errors (such as might be caused by a radiation induced upset) well. Additionally, if an entire memory device 20 fails, one of the *M* words would fail. Such a failure cannot cause more than one bit failure in each of the *N* EDAC groupings 30. This permits the use of relatively simple EDAC structures while providing the ability to survive the failure of an *N* -bit wide memory device 20. In another embodiment, by using double bit correcting EDAC codes, a memory system would be capable of tolerating simultaneous part failure and radiation induced upsets.

From the foregoing, it can be seen that there has been brought to the art a new and improved error detection and correction interleave system. It is to be understood that the preceding description of the preferred embodiment is merely illustrative of some of the many specific embodiments that represent applications of the principles of the present invention. Clearly, numerous and other arrangements would be evident to those skilled in the art without departing from the scope of the invention as defined by the following claims:

## Claims

1. An error detection and correction interleave system (18) comprising:
*M* memory devices (20), each memory device (20) having a plurality of memory addresses (22), said *M* memory devices (20) each having a plurality of *N* bit words (26), each *N* bit word (26) corresponding to one of said memory addresses (28); and
a controller (22) coupled to said *M* memory devices (20), said controller (22) collecting one bit from each of said *N* bit words (26) corresponding to one of said plurality of memory addresses (28) of said *M* memory devices (20) to generate an EDAC grouping (30) *M* bits in length, said controller (22) generating an error detection and correction code based upon said EDAC grouping (30).

2. The error detection and correction interleave system (18) of claim 1, characterized by an electronic module (24) wherein said memory devices (20) and said controller (22) are located in said electronic module (24).

3. The error detection and correction interleave system (18) of claim 1 or 2, characterized in that said controller (22) collects a new bit from each of said *N* bit words (26) *N* times to generate *N* of said EDAC groupings (30), said controller (22) then generating *N* error detection and correction codes corresponding to each of said EDAC groupings (30).

4. The error detection and correction interleave system (18) of any of claims 1 - 3, characterized in that said controller (22) is hardware based and said error detection and correction code is generated by an error detection and correction code circuit.

5. The error detection and correction interleave system (18) of any of claims 1 - 4, characterized in that said controller (22) is microprocessor based and said error detection and correction code is generated by an error detection and correction code algorithm.

6. The error detection and correction interleave system (18) of any of claims 1 - 5, characterized in that said error detection and correction code is a Hamming code.

7. The error detection and correction interleave system (18) of any of claims 1 - 6, characterized in that said error detection and correction code is capable of correcting a single bit error.

8. The error detection and correction interleave system (18) of any of claims 1 - 6, characterized in that said error detection and correction code is capable of correcting a double bit error.

9. The error detection and correction interleave system (18) of claim 8, characterized in that said error detection and correction code is capable of detecting a triple bit error.

10. A satellite error detection and correction interleave system (10) comprising:
a ground station (14);
a satellite (12) in orbit and in communication with said ground station (14), said satellite (12) having an error detection and correction interleave system (18) comprising:
*M* memory devices (20), each memory device (20) having a plurality of memory addresses (22), said *M* memory devices (20) each having a plurality of *N* bit words (26), each *N* bit word (26) corresponding to one of said memory addresses (28); and
a controller (22) coupled to said *M* memory devices (20), said controller (22) collecting one bit from each of said *N* bit words (26) corresponding to one of said plurality of memory addresses (28) of said *M* memory devices (20) to generate an EDAC grouping (30) *M* bits in length, said controller generating an error detection and correction code based upon said EDAC grouping (30).
